Europäisches Patentamt

European Patent Office

Office européen des brevets

(11) Publication number: **0 263 880 B1**

# EUROPEAN PATENT SPECIFICATION

(45) Date of publication of patent specification: **30.09.92** (51) Int. Cl.⁵: **C23C 14/32**, C23C 14/56

(21) Application number: **87901676.4**

(22) Date of filing: **11.03.87**

(86) International application number:
**PCT/JP87/00151**

(87) International publication number:
**WO 87/05637 (24.09.87 87/21)**

(54) **CONTINUOUS ION PLATING DEVICE FOR RAPIDLY MOVING FILM.**

(30) Priority: **12.03.86 JP 54163/86**
**12.03.86 JP 54165/86**

(43) Date of publication of application:
**20.04.88 Bulletin 88/16**

(45) Publication of the grant of the patent:
**30.09.92 Bulletin 92/40**

(84) Designated Contracting States:
**DE FR GB IT NL**

(56) References cited:
**EP-A- 0 112 132        EP-A- 0 161 088**
**FR-A- 2 376 485        JP-A-50 133 176**
**JP-A-61 257 471        JP-U- 5 744 170**

**VACUUM, vol. 27, no. 2, 1984, pages 64-71,
Tokyo, JP; J. URAMOTO: "Bending method of
discharge plasma flow for ion plating"**

(73) Proprietor: **TOBI CO., LTD.**
**16-14, Hanaten Nishi 2-chome, Jyoto-ku
Osaka-shi, Osaka 536(JP)**

Proprietor: **MURAYAMA, Yoichi**
**304, Domuso Mejiro, 17-44 Shimoochiai
3-chome
Shinjuku-ku, Tokyo 161(JP)**

(72) Inventor: **NOMACHI, Tetsuya**
**6-21, Tanabecho Osumigaoka 2-chome
Tuzuki-gun
Kyoto 610-03(JP)**

(74) Representative: **Davies, Christopher Robert et
al
Frank B. Dehn & Co. Imperial House 15-19
Kingsway
London WC2B 6UZ(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to apparatus for continuous ion-plating of high-speed moving film. In more detail, the invention relates to ion-plating apparatus using pressure-gradient discharge plasma.

The material manufactured so that a thin film (deposit) of a substance such as metal, inorganic substance, carbon and organic polymer is deposited on a film such as plastic and metal, is expected to be applied to various fields including conductive film, insulating membranes, display units, optical film, electron devices and decoration. Many products have been put to practical use.

The apparatus and process which ionize the particles evaporated from the raw material in a vacuum evaporation apparatus by glow discharge are well known for depositing thin film. This process is called ion-plating.

Ion-plating technology includes hollow cathode and radiofrequency exciting methods. Although these ion-plating technologies are excellent for depositing thin film, there are still many unsolved problems in depositing thin film on the surface of broad film of continuous length.

Thus, a need exists to effectively deposit markedly adhesive, thin film of uniform quality both lengthwise and crosswise on the surface of continuously moving broad film of continuous length.

However, the hollow cathode method has inevitable shortcomings-adhesion of dirt on and damage of the cathode, poor thermal stability, and heat build-up in the substrate. It is difficult, therefore, to uniformly and effectively deposit superior-quality thin film on the surface of continuously moving film.

The radiofrequency exciting method is also inadequate to efficiently deposit the thin film on the surface of film of continuous length, though the method is more effective for steady deposition of high-quality thin film.

US 4 526 132 discloses apparatus for ion-plating a fast moving film containing the features of the first part of claim 1 of the present application, but in which all of the gas in the vacuum chamber is ionized.

This invention aims to provide a new apparatus for continuous and effective deposition of thin film, free from those defects on the surface of film of continuous length. In more detail, the invention provides an ion-plating apparatus for continuous deposition of thin film on the surface of film moving at high velocity.

This invention comprises apparatus for continuous deposition of thin film by pressure-gradient plasma discharge using a winding apparatus to move the film at high velocity.

In accordance with the invention there is provided continuous ion-plating apparatus for a continuously moving film, comprising; a vacuum chamber, an exhaust system, a gas introducing system, a hearth for raw material to be evaporated for forming a thin film, means for ionizing gas in the vacuum chamber, film delivery and wind-up rolls, adapted for depositing a thin film of ionized particles on the surface of the fast moving film between the delivery roll and the wind-up roll; characterized in that the means for ionizing gas in the vacuum chamber comprises a pressure-gradient plasma gun adapted and arranged to converge the plasma flow from the pressure-gradient plasma gun on to the evaporated raw material to ionize said evaporated raw material.

The apparatus of the invention may also include a magnet apparatus for flattening the plasma flow.

A forced evaporating device for the evaporating source, guide rolls and a film cooling device may also be installed if required.

Pressure-gradient plasma discharge is made in such a way that the intermediate electrode is located between the anode and the cathode, maintaining pressure at the anode and cathode regions at approximately 133Pa (1 Torr) and 133 x $10^{-3}$Pa ($10^{-3}$ Torr) respectively. Use of this discharging method for ion-plating has already been proposed(Vacuum, Vol. 27, No. 2, p. 64, 1984).

The ion-plating apparatus is used for dry-coating on the surface of material to be treated so that plasma flow is emitted horizontally from the plasma source installed in the horizontal direction toward the hearth and turned perpendicularly right above the hearth (anode) which is placed turning upward so that the plasma converges to ionize the evaporated material.

The apparatus and process have advantages - non-adhesion of dirt on the plasma gun, high reaction rate, stabilized plasma and uniform thin film.

Ion-plating by pressure-gradient discharge has never been adequately investigated in terms of applied technology and developing practical apparatus Especially, apparatus suitable for applying dry-coating to moving articles or film and selection of operational conditions has not yet been developed. This invention has realized the above-mentioned items for the first time.

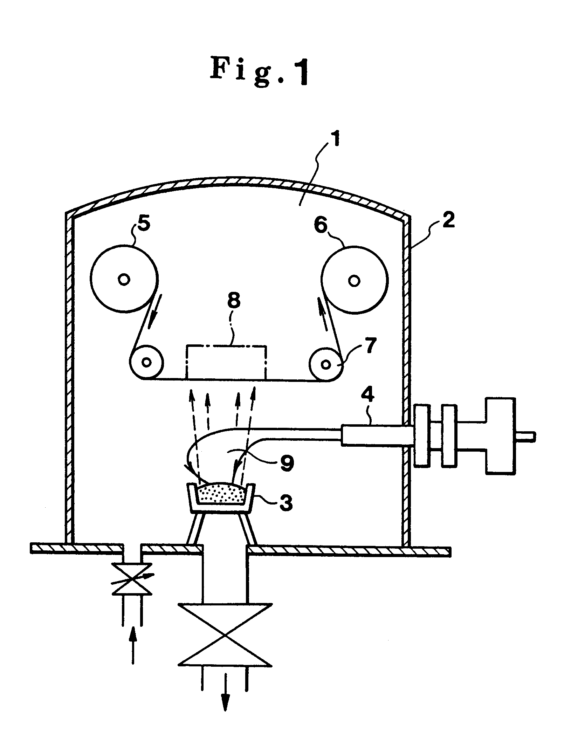

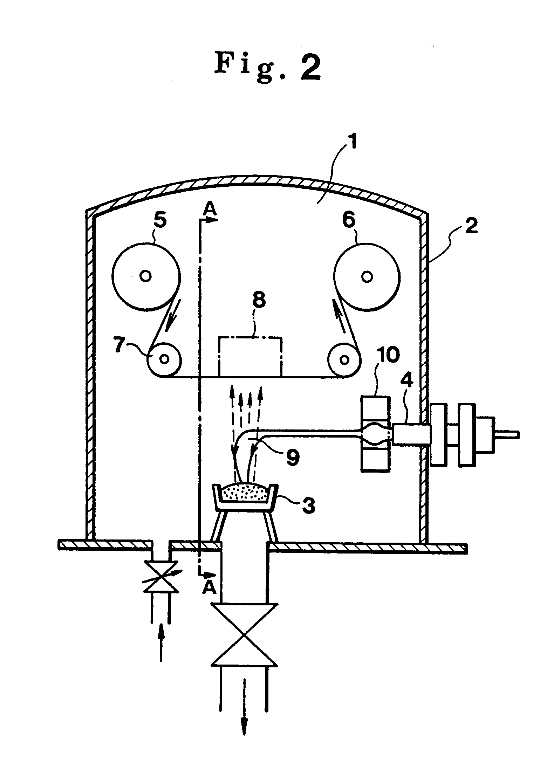

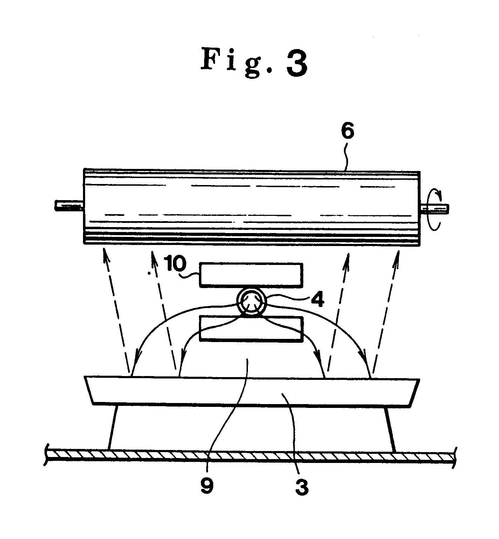

Fig. 1 shows a schematic cross-section of apparatus according to a preferred embodiment of the invention. Fig. 2 shows the schematic cross-section of the apparatus of the invention using flat plasma. Fig. 3 shows the A-A' sectional drawing of Fig. 2.

A preferred embodiment of the invention will now be described in more detail, by way of example only, with the attached figures.

Fig. 1 shows an example of the apparatus of the preferred embodiment. (1) is a vacuum chamber which is kept air-tight with a bell-jar (2). The vacuum chamber is evacuated by a vacuum pump. The bell-jar (2) has an inlet for the reaction gas and a vacuum part. The hearth (3) for the raw material for thin film, pressure-gradient plasma gun (4), film delivery roll (5) and wind-up roll (6) of transparent, conductive film are mounted in the bell-jar (2). If necessary, guide-rolls (7) and cooling device (8) can be mounted. Although the cross-section of a box-type bell-jar is shown in the figure, the shape and construction are not necessarily limited to this type.

A water-cooling or air-cooling device is installed to cool the driving gear of the rolls. A forced heating device such as an electric resistance heater, electron-beam heater, high-frequency heater, etc. can be used for the hearth, taking the evaporated material and productivity into consideration.

The bell-jar may be furnished with a gate on the side wall to freely take in and remove the part containing the rolls, the part containing rolls with the cooling device or the part of the hearth through the gate.

Naturally, the apparatus of the invention is not necessarily limited to the above-mentioned components.

For instance, the part containing rolls is not necessarily installed in pre-treatment sections such as the plasma bombarding treatment or the post-treatment section adjoining the thin-film depositing section to pass the film through the slit formed on the side wall of the bell-jar. A device applying negative voltage to the surface and the opposite side of the depositing surface of thin film can be also installed.

Fig. 2 shows an example of the apparatus of the invention using sheet plasma flow. The apparatus has a magnet for flattening the plasma.

(1) is a vacuum chamber which is kept air-tight with a bell-jar (2). The vacuum chamber is evacuated by a vacuum pump. The hearth (3) for the raw material for thin film, pressure-gradient plasma gun (4), film delivery roll (5) and wind-up roll (6) of the transparent, conductive film are mounted in the bell-jar (2). If necessary, guide-rolls (7) and cooling device (8) may be installed. (9) is plasma flow and (10) is a magnet to flatten the plasma flow. Although the cross-section of the box-type bell-jar is shown in the figure, the shape and construction are not necessarily limited to this type.

Fig. 3 is the A-A' sectional diagram of the apparatus shown in Fig. 2. The plasma flow is flattened and broadened crosswise. This allows the application of effective ion-plating to large, broad film.

The operational conditions of the continuous ion-plating apparatus for high-speed moving film shown in the figure can be chosen according to uses of the intended thin-film deposited.

Any heat-resistant film made from material such as polyester, polysulfone, polyamide, metal, ceramic or their composite can be used for film moving at high velocity, which can be controlled in a wide range from 6 to 30 m/min.

The material used for thin film is not especially limited and can be chosen from among metals and inorganic and organic materials.

Reaction pressure widely ranges from $1.3 \times 10^{-3}$Pa to 13Pa ($1 \times 10^{-5}$ to $10^{-1}$ Torr). Gas such as argon, helium and hydrogen and reactive gas such as oxygen, nitrogen and organic monomer can be used.

Discharge voltage is chosen in the range from 50 to 150V. The current is chosen according to the evaporated material.

This invention will now be further illustrated by an example.

Example

Conductive thin-film can be manufactured by apparatus provided with a bell-jar with a diameter of 1 m shown in Fig. 1 as follows:

Polyethylene terephthalate (PET) film, 230mm wide, was used. ITO containing 5% $SnO_2$ was used as the evaporated material. The distance between the hearth for deposition and the film was 40cm. No cooling device was used.

The moving or winding velocity was fixed at 20m/min.

| (1) | Discharge: | 250A/70V |
| | Pressure of argon: | $10 \times 10^{-2}$Pa ($7.5 \times 10^{-4}$ Torr) |
| | Pressure of oxygen: | $11 \times 10^{-2}$Pa ($8 \times 10^{-4}$ Torr) |
| (2) | Discharge: | 240A/65V |
| | Pressure of argon: | $11.3 \times 10^{-2}$Pa ($8.5 \times 10^{-4}$ Torr) |
| | Pressure of oxygen: | $13.3 \times 10^{-2}$Pa ($1.0 \times 10^{-3}$ Torr) |

In Experiment (1), a transparent, thin film with a thickness of 120nm (1200 Å) and 85% parallel light transmission of 550nm (87% in the PET blank test) was obtained. The film resistance was 95 to 106Ω/□.

Also, in Experiment (2), film with a similar light transmission was obtained. The resistance of the film was 110 to 115Ω/□.

By this invention, it is now possible to continuously manufacture multi-functional film, which is approximately 100 to 1500mm wide, at a velocity as high as 6 to 30m/min, a result which is not possible with conventional technologies.

The apparatus of this invention is very useful for depositing thin film on the surface of film moving at high velocity. High-quality thin-film used for various applications such as conductive thin-film, which is useful for indication elements, touch panels, electromagnetic wave shields as well as optical film and insulating membranes can be effectively manufactured by roll-to roll ion-plating.

**Claims**

1. Continuous ion-plating apparatus for a continuously moving film, comprising; a vacuum chamber (1), an exhaust system, a gas introducing system, a hearth (3) for raw material to be evaporated for forming a thin film, means (4) for ionizing gas in the vacuum chamber (1), film delivery (5) and wind-up rolls (6), adapted for depositing a thin film of ionized particles on the surface of the fast moving film between the delivery roll (5) and the wind-up roll (6); characterized in that the means for ionizing gas in the vacuum chamber comprises a pressure-gradient plasma gun (4) adapted and arranged to converge the plasma flow (9) from the pressure-gradient plasma gun (4) on to the evaporated raw material to ionize said evaporated raw material.

2. Continuous ion-plating apparatus as claimed in Claim 1 further comprising a magnet (10) for flattening the plasma flow (9) emitted from the pressure-gradient plasma gun (4).

3. Continuous ion-plating apparatus as claimed in Claim 1 or 2 further comprising a forced evaporating device for said hearth (3).

4. Continuous ion-plating apparatus as claimed in Claim 1, 2 or 3 further comprising guide-rolls (7) for guiding said continuously moving film.

5. Continuous ion-plating apparatus as claimed in Claim 1, 2, 3 or 4 further comprising a film cooling device (8) for cooling said continuously moving film.

**Patentansprüche**

1. Kontinuierliche Ionenplattierungsanordnung für einen kontinuierlich sich bewegenden Film, mit einer Vakuumkammer (1), einem Abgassystem, einem Gaseinbringsystem, einer Erhitzungseinrichtung (3) für ein zur Bildung eines dünnen Films zu verdampfendes Rohmaterial, einer Einrichtung (4) zur Ionisierung von Gas in der Vakuumkammer (1) und einer Filmabgabe(5) und Filmaufwickelrolle (6) zur Abscheidung eines dünnen Films aus ionisierten Partikeln auf der Oberfläche des schnell sich zwischen der Abgaberolle (5) und der Aufwickelrolle (6) bewegenden Films, **dadurch gekennzeichnet,** daß die Einrichtung zur Ionisierung von Gas in der Vakuumkammer eine Druckgradientenplasmakanone (4) aufweist, die so ausgebildet und angeordnet ist, daß der Plasmastrom (9) von der Druckgradientenplasmakanone (4) auf das verdampfte Rohmaterial zur Ionisierung des verdampften Rohmaterials konvergiert.

2. Kontinuierliche Ionenplattierungsanordnung nach Anspruch 1, mit einem Magneten (10) zum Abflachen des von der Druckgradientenplasmakanone (4) emittierten Plasmastroms (9).

**3.** Kontinuierliche Ionenplattierungsanordnung nach Anspruch 1 oder 2, mit einer Zwangverdampfungseinrichtung für die Erhitzungskammer (3).

**4.** Kontinuierliche Ionenplattierungsanordnung nach Anspruch 1, 2 oder 3, mit Führungsrollen (7) zum Führen des kontinuierlich sich bewegenden Films.

**5.** Kontinuierliche Ionenplattierungsanordnung nach Anspruch 1, 2, 3 oder 4, mit einer Filmkühleinrichtung (8) zum Kühlen des kontinuierlich sich bewegenden Films.

**Revendications**

**1.** Appareil de revêtement ionique continu d'un film se déplaçant de façon continue, comprenant une chambre à vide (1), un circuit d'évacuation, un circuit d'introduction de gaz, un creuset (3) destiné à contenir une matière première qui doit être évaporée pour la formation d'un film mince, un dispositif (4) d'ionisation du gaz de la chambre à vide (1), et des rouleaux débiteur (5) et récepteur (6) de film, et destiné au dépôt d'un film mince de particules ionisées à la surface du film qui se déplace rapidement entre le rouleau débiteur (5) et le rouleau récepteur (6), caractérisé en ce que le dispositif d'ionisation du gaz dans la chambre à vide comprend un pistolet (4) à plasma à gradient de pression dont la disposition et l'adaptation assurent la convergence du courant de plasma (9) provenant du pistolet (4) à plasma à gradient de pression sur la matière première évaporée afin que celle-ci soit ionisée.

**2.** Appareil de revêtement ionique continu selon la revendication 1, comprenant en outre un aimant (10) destiné à aplatir le courant de plasma (9) émis par le pistolet (4) à plasma à gradient de pression.

**3.** Appareil de revêtement ionique continu selon la revendication 1 ou 2, comprenant en outre un dispositif d'évaporation forcée pour le creuset (3).

**4.** Appareil de revêtement ionique continu selon la revendication 1, 2 ou 3, comprenant en outre des rouleaux de guidage (7) destinés à guider le film mobile de façon continue.

**5.** Appareil de revêtement ionique continu selon la revendication 1, 2, 3 ou 4, comprenant en outre un dispositif (8) de refroidissement du film qui se déplace de façon continue.

# Fig.1

# Fig. 2

# Fig. 3